(19) Europäisches Patentamt
European Patent Office
Office européen des brevets

(11) Publication number: 0 042 704 B1

(12) EUROPEAN PATENT SPECIFICATION

(45) Date of publication of patent specification: 20.03.85

(51) Int. Cl.$^4$: G 03 C 1/54, H 01 J 29/22

(21) Application number: 81302620.0

(22) Date of filing: 12.06.81

# (54) Method of forming a pattern employing a photosensitive composition.

(30) Priority: 20.06.80 JP 82882/80

(43) Date of publication of application:
30.12.81 Bulletin 81/52

(45) Publication of the grant of the patent:
20.03.85 Bulletin 85/12

(84) Designated Contracting States:
DE FR GB NL

(56) References cited:
DE-A-2 815 894
DE-B-1 693 195
DE-B-2 166 264

(73) Proprietor: Hitachi, Ltd.
5-1, Marunouchi 1-chome
Chiyoda-ku Tokyo 100 (JP)

(72) Inventor: Morishita, Hajime
6-24-1, Chuou
Ohta-ku Tokyo (JP)
Inventor: Kohashi, Takahiro
2-32-A201, Koyasu-cho
Hachioji-shi Tokyo (JP)
Inventor: Hayashi, Nobuaki
2-32-A202, Koyasu-cho
Hachiogi-shi Tokyo (JP)
Inventor: Akagi, Motoo
2196-146, Hirar Hinodemachi
Nishitama-gun Tokyo (JP)
Inventor: Uchino, Shoichi
1-48-18, Akatsuki-cho
Hachioji-shi Toyko (JP)
Inventor: Nonogaki, Saburo
3-17-24, Kamimeguro
Meguro-ku Tokyo (JP)

(74) Representative: Paget, Hugh Charles Edward et al
MEWBURN ELLIS & CO. 2/3 Cursitor Street
London EC4A 1BQ (GB)

EP 0 042 704 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to a method of forming a pattern employing a photosensitive composition.

The inner surface of the screen (faceplate) of a color picture tube is coated with three different phosphors arranged in dots or stripes. A known method of forming this phosphor coating layer is as follows.

First, a coating material of a mixture consisting of the phosphor of the first color and a photosensitive resin is applied on the inner surface of the faceplate and dried to form a film. Then, this layer is irradiated with ultraviolet radiation through the apertures of a shadow mask, the locations so irradiated being those at which an electron beam is to impinge to cause the phosphor to luminesce, i.e. the locations at which the phosphor is to be secured. The photosenitive resin of each irradiated location becomes insoluble, so that the whole layer at the location is insoluble. Next, the coating layer is washed with a solvent to leave only the insoluble parts on the faceplate surface and to dissolve and remove the other parts.

Subsequently, similar operations are performed with a layer of a mixture consisting of the phosphor of the second color and the photosensitive resin, and then with a mixture consisting of the phosphor of the third color and the photosensitive resin.

As is apparent from this description, this process is complicated and requires the repetition of the large number of operations of wet coating, washing and drying. Simplification of the process is very desirable.

To this end, some of the present inventors have previously proposed in Japanese Laid-open Patent Application No. 53-126861 (corresponding to DE—A—2815 894), a method of forming the phosphor screen of a color picture tube which is conspicuously simpler than the prior art method. This method is derived from the new knowledge that the photodissociation product of an aromatic diazonium salt has a powder particle acceptability. It is characterized in that (1) a photosensitive composition which contains an aromatic diazonium salt as photosensitive component and which becomes tacky when exposed to light is applied as a thin layer to the inner surface of the faceplate of a color picture tube, (2) the thin layer is exposed to light in a pattern, to cause tackiness in the exposed areas, and (3) particles of a phosphor powder are brought into contact with the thin layer after this exposure so as to be accepted by the thin layer.

In this method, only the exposure and the powder contacting need to be repeated for phosphors of the second and third colors, and, once the coating film has been formed, patterns of any number of different phosphors can be formed. A black matrix can be formed by employing a light absorbing substance, for example, carbon powder.

With this method, however, the operational time is somewhat increased because the sensitivity of the photosensitive component used is somewhat lower than in the prior-art photosensitive resin.

The following references also are cited to show the state of the art:

GB—A—1,103,865

GB—A—1,105,112

This invention provides a method of forming a pattern on a face-plate using a composition of high sensitivity.

The present invention is defined in the claims.

Preferably A is $Cl.\frac{1}{2}ZnCl_2$, $BF_4$ or $HSO_4$.

Examples of the compound of the general formula (b) in compositions employed in the method of the invention are as follows:

2-methyl-4-(dimethylamino) benzene diazonium chloride zinc chloride double salt:

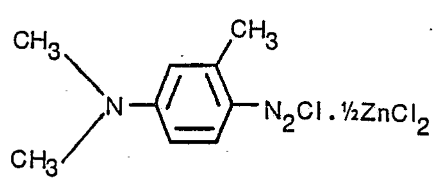

(I)

2-methoxy-4-(dimethylamino) benzene diazonium, chloride zinc chloride double salt:

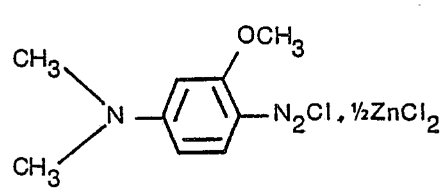

(II)

3-methoxy-4-(dimethylamino) benzene diazonium chloride zinc chloride double salt:

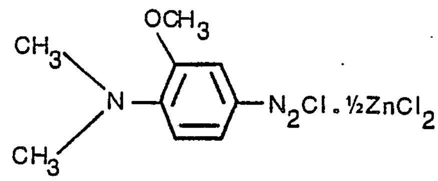

(III)

2,5-dimethyl-4-(dimethylamino) benzene diazonium chloride zinc chloride double salt:

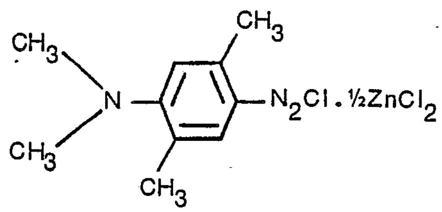

(IV)

3,5-dimethyl-4-(dimethylamino) benzene diazonium chloride zinc chloride double salt:

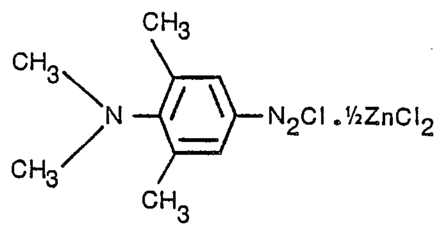

(V)

2,6-dimethyl-4-(dimethylamino) benzene diazonium chloride zinc chloride double salt:

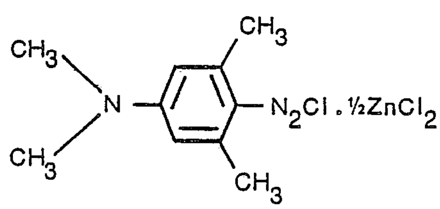

(VI)

As stated in Japanese Laid-open Patent Application No. 53-126861, the coating film containing the photosensitive component should preferably be in a crystallized state. Unless it is, some powder may deposit also on the unexposed parts. This is very important. More specifically, deposition of phosphor powder on the unexposed parts is a cause for cross-contamination, which degrades the quality of the color picture tube. The diazonium compound selected should, accordingly, be one of high sensitivity which is readily crystallized.

Compounds differing from the diazonium compounds of formula (b) defined above only in that $R_1$ and $R_2$ contains 3 or more carbon atoms are difficult to crystallize. Therefore, if such a diazonium compound were to be used, desired results would be achieved only if, after the formation of the coating film, crystallization were promoted by a method such as sprinkling fine powder of crystals of the compound. This extra step is unfavourable in industrial application.

With the aim of enhancing the coating property, etc., when forming the photosensitive component into a thin layer as will be described later, the composition preferably additionally includes a water-soluble polymer compound. However, when the polymer compound is mixed in, the crystallinity of the diazonium compound (b) worsens. If, in such a composition, the dimethylamino compound (b) were to be replaced by a corresponding compound wherein the number of carbon atoms in $R_1$ or $R_2$ is 2, for example the N,N-diethylamino compound, then that compound would be hard to crystallize. Hence a composition used in a method of the invention contains an N, N-dimethylamino compound. Two or more such compounds (b) may be used in admixture.

As A in the general formula (b), the use of $Cl.\frac{1}{2}ZnCl_2$ is preferable because it gives excellent crystallinity.

The N, N-dimethylamino compound (b) is inferior in crystallinity to aromatic diazonium compounds which have previously been employed in such methods. The composition employed in the method of the present invention therefore contains, in addition to the abovementioned diazonium compound of general formula (b), another aromatic diazonium compound (a) namely 4-(dimethylamino) benzene diazonium

chloride zinc chloride double salt, which is previously described in JP—A—53—126861. The proportion of the other aromatic diazonium compound (a) and the diazonium compound (b) falls within a range of from 9:1 to 1:2 (weight ratio); in other words, the diazonium compound (b) is present in an amount within a range from 10 to 66.7 weight-% with respect to the total weight of mixed diazonium compounds (a) and (b). The reason for this is that if the ratio were 9:1 or lower, there would be an enhancement in sensitivity, while if the ratio were 1:2 or above, crystallinity would be enhanced.

A large number of aromatic diazonium compounds are generally known. As stated before, a characterizing feature of this invention consists in that diazonium compounds (b) of excellent crystallinity and high sensitivity are employed. The reasons for the choice of methyl for each of $R_1$ and $R_2$ in the general formula (b) have already been described. Further, if the groups of $R_3$ and $R_4$ had been alkyl or alkoxy radicals containing 2 or more carbon atoms, for example, ethyl or ethoxy radicals their crystallinity would have been worse. Therefore, the invention is characterized in that a diazonium compound having $R_1$, $R_2$, $R_3$ and $R_4$ as defined in the general formula (b) which become tacky when exposed to light is employed as a photosensitive component. It is also characterized in that the compound (b) is admixed with 4-(dimethylamino) benzene diazonium chloride zinc chloride double salt to give compositions having excellent photosensitivity and high sensitivity.

As mentioned above, in order to enhance the suitability for coating when forming a thin layer of the above photosensitive composition used in the method of this invention, an organic polymer compound and/or surfactant is preferably included in the photosensitive composition. Especially preferred as the organic polymer compounds are, for example, gum arabic, polyvinyl alcohol, polyacrylamide, poly-N-vinyl pyrrolidone, hydroxypropyl methyl cellulose, alginic acid, propylene glycol ester of alginic acid, acrylamide-diacetoneacrylamide copolymer, and methyl vinyl ether-maleic anhydride copolymer. The organic polymer compounds preferably amount to 0.5—500 weight-% with respect to the total weight of the aromatic diazonium compounds (a) and (b). The surfactant preferably amounts to 0.01—1 weight-%.

In the manufacturing process for a color picture tube, after a phosphor screen is formed with a powder coating layer, it is covered with an organic polymer film. The purpose of this step is that, when forming an aluminium film as a light reflective film by vacuum evaporation, the aluminium film is endowed with metallic luster. In the step of covering with the polymer film, it is desirable that the phosphor screen is mechanically rigid.

One expedient for rendering the powder coating layer mechanically rigid is to bring a vapour of an alkaline material, for example, ammonia, hydrazine and aliphatic amine, into contact with the powder coating layer. By this, a substance produced by the light irradiation, for example zinc choride, changes into a water-insoluble substance, for example zinc hydroxide, so that the powder layer becomes mechanically rigid.

By way of example, the air which has passed through concentrated ammonia water (concentration: about 29%) at a temperature of above about 20°C is held in contact with the powder coating layer for 10—20 seconds.

Methods embodying this invention are described in more detail with reference to the following Examples 5 to 8. Firstly processes for synthesizing compounds within the above general formula (b) are described in Examples 1 to 4.

Example 1

50 g of m-toluidine was suspended in 140 g of water. At room temperature, 118 g of dimethyl sulfate was dropped into the suspension, and 149 g of a 30%-aqueous solution of sodium hydroxide was subsequently added, to dimethylate some of the amino radicals. 28 g of N, N-dimethylamino-m-toluidine thus obtained was dissolved in hydrochloric acid. While the solution was held at or below 15°C, 53 g of a 30%-aqueous solution of sodium nitrite was added, to produce a nitroso-compound. After this had been reduced, it was diazotized with sodium nitrite by conventional hydrochloric acid acidification. Zinc chloride in an amount of three molar equivalents was added to the resultant compound, to form a zinc chloride double salt. This compound was recrystallized with dilute hydrochloric acid. From the following analytical values, it was confirmed as the compound of the above Formula I.

Infrared absorption spectrum (KBr tablet method): 2,100 $cm^{-1}$ ($\nu_{N=N}$), 1,580 $cm^{-1}$ ($\nu_{C=C}$), 1,360 $cm^{-1}$ ($\nu_{C=N}$), 860 and 800 $cm^{-1}$ (substituted aromatic ring). Ultraviolet absorption spectrum (solvent-water): maximum absorption wavelength 376 nm, molar extinction coefficient $3.9 \times 10^4$. Zinc analytical value (EDTA chelate titration): 13.1% (calculated value: 12.3%).

Example 2

Using 2-methoxyaniline as a starting material, a process similar to that of Example 1 was conducted to synthesize the compound of the above Formula III. The following analytical values were obtained.

Infrared absorption spectrum: 2,160 $cm^{-1}$ ($\nu_{N=N}$), 1,52C and 1,570 $cm^{-1}$ ($\nu_{C=C}$), 1,370 $cm^{-1}$ ($\nu_{C=N}$), 860 and 800 $cm^{-1}$ (substituted aromatic ring). Ultraviolet absorption spectrum: maximum absorption wavelength 405 nm, molar extinction coefficient; $3.0 \times 10^4$. Zinc analytical value (atomic absorption analysis): 11.6% (calculated value: 11.6%).

Example 3

Using 2, 5-dimethylaniline as a starting material, a process similar to that of Example 1 was conducted to synthesize the compound of above Formula IV. The following analytical values were obtained.

Infrared absorption spectrum: 2,120 $cm^{-1}$ ($v_{N=N}$), 1,580 $cm^{-1}$ ($v_{C=C}$), 880 and 840 $cm^{-1}$ (substituted aromatic ring). Ultraviolet absorption spectrum: maximum absorption wavelength 390 nm, molar extinction coefficient $3.8 \times 10^4$. Zinc analytical value (atomic absorption analysis): 11.3% (calculated value: 11.7%).

Example 4

Using 3, 5-dimethylaniline as a starting material, a process similar to that of Example 1 was conducted, to synthesize the compound of the above Formula VI. The following analytical values were obtained.

Infrared absorption spectrum: 2,150 $cm^{-1}$ ($v_{N=N}$), 1,600 $cm^{-1}$ ($v_{C=C}$), 1,370 $cm^{-1}$ ($v_{C=N}$), 860 and 850 $cm^{-1}$ (substituted aromatic ring). Ultraviolet absorption spectrum: maximum absorption wavelength 375 nm, molar extinction coefficient $3.0 \times 10^4$. Zinc analytical value (EDTA chelate titration): 15.7% (calculated value: 11.7%).

Example 5

The 2-methyl-4-(dimethylamino) benzene diazonium chloride zinc chloride double salt (Formula 1) and 4-(dimethylamino) benzene diazonium chloride zinc chloride double salt were mixed at a weight ratio of 1:9. A 0.5%-aqueous solution of propylene glycol ester of alginic acid was added to the mixture so that the solid content thereof became 10 weight-% of the total quantity of the diazonium compounds. The resultant solution as applied on a glass substrate by spin coating, to form a crystallized film having a thickness of approximately 0.5 µm. Using an ultrahigh-pressure mercury vapor lamp of 500 W, the film was irradiated through a shadow mask for 220 seconds at a distance of 135 cm from the lamp. When phosphor powder was brought into contact with the irradiated film, it was deposited at the parts exposed to the light.

For comparison, a similar operation was carried out employing only the 4-(dimethylamino) benzene diazonium chloride zinc chloride double salt, without using the compound of Formula 1. The phosphor adhered in a substantially equal amount when the irradiation was performed for 250 seconds.

Examples 6—8

Similar processes were conducted replacing the diazo-compound of Formula I in Example 5 with diazo-compounds listed in the following table and by changing the weight ratio between the particular diazo-compound and the 4-dimethylamino) benzene diazonium chloride zinc chloride double salt as indicated in the table. The phosphor adhered in substantially equal amounts to that in Example 5 following the irradiation periods listed in fourth column of the table.

TABLE

| Example No. | Compound | Weight ratio | Irradiation time |
|---|---|---|---|
| 6 | Formula III | 1 to 4 | 200 seconds |
| 7 | Formula IV | 1 to 4 | 210 seconds |
| 8 | Formula VI | 1 to 4 | 210 seconds |

**Claims**

1. A method of forming a pattern of a powder coating layer on a faceplate of a color picture tube by applying a thin film of a photosensitive composition on the inner surface of the faceplate, exposing said thin layer to light in a desired pattern to cause the exposed parts to become tacky, and bringing powder particles into contact with the exposed parts of the thin layer so that the powder adheres thereto, characterized in that said photosensitive composition contains (a) a compound which is 4-(dimethylamino) benzene diazonium chloride zinc chloride double salt and (b) an aromatic diazonium compound of the general formula:

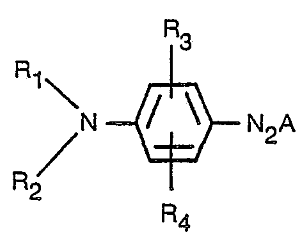

(b)

where $R_1$ and $R_2$ are both methyl, $R_3$ and $R_4$ are each one of H, $CH_3$ or $OCH_3$ except that $R_3$ and $R_4$ cannot both be H, and A is a moiety selected so that the compound has sufficient crystallinity for use as a photosensitive composition and becomes tacky when exposed to light, the said compounds (a) and (b) being present in the weight ratio (a):(b) in the range 9:1 to 1:2.

2. A method according to claim 1 in which A is $Cl.\frac{1}{2}ZnCl_2$, $BF_4$ or $HSO_4$.

3. A method according to claim 1 or claim 2, wherein A is $Cl.\frac{1}{2}ZnCl_2$.

4. A method according to claim 3, wherein said aromatic diazonium compound is 2-methyl-4-(dimethylamino) benzene diazonium chloride zinc chloride double salt.

5. A method according to claim 3, wherein said aromatic diazonium compound is 3-methoxy-4-(dimethylamino) benzene diazonium chloride zinc chloride double salt.

6. A method according to claim 3, wherein said aromatic diazonium compound is 2,5-dimethyl-4-(dimethylamino) benzene diazonium chloride double salt.

7. A method according to claim 3, wherein said aromatic diazonium compound is 2,6-dimethyl-4-(dimethylamino) benzene diazonium chloride zinc chloride double salt.

8. A method according to any one of claims 1 to 7, further containing an organic polymer compound in a range of 0.5 to 500 weight-% with respect to the total quantity of said aromatic diazonium compound.

9. A method according to claim 8, wherein said organic polymer compound is at least one of gum arabic, polyvinyl alcohol, polyacrylamide, poly-N-vinyl pyrrolidone, hydroxypropyl methyl cellulose, alginic acid, propylene glycol ester of alginic acid, acrylamide-diacetoneacrylamide copolymer, and methyl vinyl ether-maleic anhydride copolymer.

**Patentansprüche**

1. Verfahren zur Ausbildung eines Musters aus einer Pulver-Überzugsschicht auf dem Schirmträger einer Farbbildröhre durch Auftragen eines dünnen Films aus einer lichtempfindlichen Zusammensetzung auf die innere Oberfläche des Schirmträgers, Bestrahlen dieser dünnen Schicht mit Licht in einem gewünschten Muster, um das Klebrigwerden der bestrahlten Teile zu verursachen, und Inberührungbringen von Pulverteilchen mit den bestrahlten Teilen der dünnen Schicht, do daß das Pulver an diesen haftet, dadurch gekennzeichnet, daß die lichtempfindliche Zusammensetzung (a) eine Verbindung, welche ein 4-(Dimethylamino)-benzoldiazoniumchlorid-Zinkchlorid-Doppelsalz darstellt und (b) eine aromatische Diazoniumverbindung der allgemeinen Formel

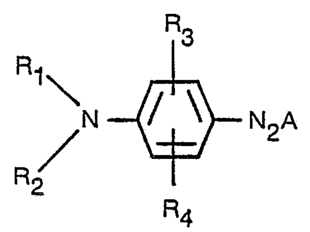

(b)

enthält, in der beide Reste $R_a$ und $R_2$ Methylgruppen sind, $R_3$ und $R_4$ jeweils für H, $CH_3$ oder $OCH_3$ stehen, mit der Maßgabe, daß nicht beide Reste $R_3$ und $R_4$ für H stehen können, und A einen Rest darstellt, der so ausgewählt ist, daß die Verbindung ausreichende Kristallinität zur Verwendung als lichtempfindliches Material besitzt und klebrig wird, wenn sie mit Licht bestrahlt wird, wobei die Verbindungen (a) und (b) in einem Gewichtsverhältnis (a):(b) im Bereich von 9:1 bis 1:2 vorliegen.

2. Verfahren nach Anspruch 1, bei dem A für $Cl.\frac{1}{2}ZnCl_2$, $BF_4$ oder $HSO_4$ steht.

3. Verfahren nach Anspruch 1 oder 2, bei dem A für $Cl.\frac{1}{2}ZnCl_2$ steht.

4. Verfahren nach Anspruch 3, bei dem die aromatische Diazoniumverbindung ein 2-Methyl-4-(dimethylamino)-benzoldiazoniumchlorid-Zinkchlorid-Doppelsalz ist.

5. Verfahren nach Anspruch 3, bei dem die aromatische Diazoniumverbindung ein 3-Methoxy-4-(dimethylamino)-benzoldiazoniumchlorid-Zinkchlorid-Doppelsalz ist.

6. Verfahren nach Anspruch 3, bei dem die aromatische Diazoniumverbindung ein 2,5-Dimethyl-4-(dimethylamino)-benzoldiazoniumchlorid-Zinkchlorid-Doppelsalz ist.

7. Verfahren nach Anspruch 3, bei dem die aromatische Diazoniumverbindung ein 2,6-Dimethyl-4-(dimethylamino)-benzoldiazoniumchlorid-Zinkchlorid-Doppelsalz ist.

8. Verfahren nach einem der Ansprüche 1 bis 7, bei dem außerdem eine organische polymere Verbindung in einer Menge im Bereich von 0,5 bis 500 Gew.-%, bezogen auf die Gesamtmenge der aromatischen Diazoniumverbindung, vorliegt.

9. Verfahren nach Anspruch 8, bei dem die organische polymere Verbindung mindestens eine der nachstehenden Verbindungen ist: Gummiarabicum, Polyvinylalkohol, Polyarcylamid, Poly-N-vinylpyrrolidon, Hydroxypropylmethylcellulose, Alginsäure, Propylenglykolester von Alginsäure, Acrylamid-Diacetonacrylamid-Copolymeres und Methylvinylether-Maleinsäureanhyrid-Copolymeres.

**Revendications**

1. Procédé de formation d'un dessin formé d'une couche de revêtement en poudre sur une plaque frontale d'un tube-image en couleurs, moyennant l'application d'une pellicule mince d'une composition photosensible dur la surface intérieure de la plaque frontale, l'exposition de ladite couche mince à la lumière selon un dessin désiré de manière que les parties exposées deviennent collantes, et l'apposition de particules de poudre en contact avec les parties exposées de la couche mince de manière que la poudre y adhère, caractérisé en ce que ladite composition photosensible contient (a) un composé qui est le sel double de chlorure de 4-(diméthylamino) benzène-diazonium et de chlorure de zinc et (b) un composé aromatique du diazonium de formule générale:

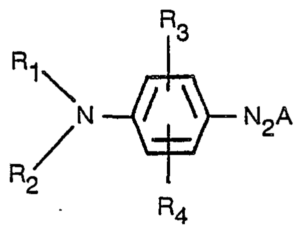

(b)

dans laquelle $R_1$ et $R_2$ représentent tous les deux le groupe méthyl, $R_3$ et $R_4$ sont constitués chacun par l'un des groupes H, $CH_3$ ou $OCH_3$, hormis que $R_3$ et $R_4$ ne peuvent pas être tous les deux H, et A est une moitié sélectionnée de telle sorte que les composés possédent une cristallinité suffisante pour être utilisés en tant que composition photosensible et devient collant lorsqu'il est exposé à la lumière, lesdits composés (a) et (b) étant présents dans le rapport pondéral (a):(b) compris dans la gamme allant de 9:1 à 1:2.

2. Procédé selon la revendication 1, dans lequel du A et du $Cl.\frac{1}{2}ZnCl_2$, $BF_4$ ou $HSO_4$.

3. Procédé selon la revendication 1 ou 2, selon lequel A est du $Cl.\frac{1}{2}ZnCl_2$.

4. Procédé selon la revendication 3, dans lequel ledit composé aromatique de diazonium est le sel double de chlorure de 2-méthyl-4-(diméthylamino) benzène-diazonium) et de chlorure de zinc.

5. Procédé selon la revendication 3, dans lequel ledit composé aromatique de diazonium est le sel souble de chlorure de 3-méthoxy-4-(diméthylamino) benzène-diazonium et de chlorure de zinc.

6. Procédé suivant la revendication 3, dans lequel ledit composé aromatique de diazonium et le sel double de chlorure de 2,5-diméthyl-4-(diméthylamino) benzène-diazonium et de chlorure de zinc.

7. Procédé suivant la revendication 3, dans lequel ledit composé aromatique de diazonium est le sel double de chlorure de 2,6-diméthyl-4-(diméthylamino) benzène-diazonium et de chlorure de zinc.

8. Procédé selon l'une quelconque des revendications 1 à 7, contenant en outre un composé polymère organique dans une gamme comprise entre 0,5 et 500% en poids comptés par rapport à la quantité totale dudit composé aromatique de diazonium.

9. Procédé selon la revendication 8, selon lequel ledit composé polymère organique est au moins l'un des éléments suivants: gomme arabique, alcool polyvinylique, polyacrylamide, poly-N-vinylpyrrolidone, hydroxypropyl méthyl cellulose, acide alginique, ester de propylène glycol de l'acide alginique, copolymère d'acrylamide-diacétone acrylamide, et copolymère de méthyl vinyl éther-anydride maléique.